# EUROPEAN PATENT APPLICATION

(11) **EP 1 901 188 A1**
(43) Date of publication of application: **19.03.2008**
(21) Application number: 06120523.3
(22) Date of filing: 12.09.2006
(51) Int. Cl.: G06F 17/50, G06T 11/00, G06T 5/00, G06T 11/60

(54) **Chip art calendar**

(71) Applicant: EM Microelectronic-Marin SA, 2074 Marin (CH)
(72) Inventor: Hruska, Ondrej, 14100 Praha 4 (CZ)
(74) Representative: Couillard, Yann Luc Raymond

(57) **Abstract**

A method for transforming a chip layout into an artwork comprising the steps of: (S1) designing a chip layout under a computer-aided design software having an original file format unreadable with an image retouching software; (S2) converting said original file format of the chip layout into a chip layout file having a file format readable with an image retouching software; (S3) retouching said image file into an artwork by applying a complex filter with at least two main parameters among with brushing strokes, brushing bristles, swirling, blurring, 3D surfacing, edge mode wrapping, blending, skewing, applying topography, solarizing, changing coordinates system; (S4) displaying said resulting artwork.

## Description

### FIELD OF THE INVENTION

The present invention generally relates to image processing by computer-aided software and more particularly relates to transformation of a technical image into an artwork.

### BACKGROUND OF THE INVENTION

Nowadays, use of computer-aided design is well known to realise any technical schematic, electronic circuit or any other technical design.

On the other side, in parallel to the increase number of digital cameras sold, image retouching software have also increase drastically to let users to retouch their pictures and make some art work on them.

### SUMMARY OF THE INVENTION

Within the scope of the present invention, it has been shown that a selection of some technical design may become an original artwork after some specific image retouching processes. This is particularly true with a chip layout design which contains a complex association of colours, shapes and lines. Based on that selection, one goal of the present invention is thus to implement a method for transforming a chip layout into an artwork comprising the steps of:
- designing a chip layout under a computer-aided design software having an original file format unreadable with an image retouching software;
- converting said original file format of the chip layout into a chip layout file having a file format readable with an image retouching software;
- retouching the image file into an artwork by applying a complex filter with at least two parameters among with brushing strokes, brushing bristles, swirling, blurring, 3D surfacing, edge mode wrapping, blending, skewing, applying topography, solarizing, changing coordinates system;
- displaying the resulting artwork.

Specific filters having some aesthetic visual effects form the subject matter of dependent claims. In particular, it is disclosed an impressionist filter using at least wide brushing strokes and brushing bristles at a low density; a misty filter using at least narrow brushing strokes and brushing bristles at a high density; a downpour filter using at least swirling and 3D surfacing; a lunar filter using at least topographic blurring and blending; a fireworks filter using at least a coordinate system changing and solarizing; a puddle filter using at least blurring and blending.

The resulting artworks may be used within different applications among with a screensaver, wallpaper, or calendar applications.

### BRIEF DESCRIPTION OF THE DRAWINGS

Other aspects, features and advantages of the present invention will be apparent upon reading the following detailed description of non-limiting examples and embodiments made with reference to the accompanying drawings.
- Figure 1 represents a diagram of the different steps of the transforming method according to the invention;
- Figures 2a-2c represent one example of transforming a chip layout according to the invention;
- Figures 3-6 represent different artworks obtained by different specific filters;
- Figures 7a-7b represent another example of transformation for another chip layout.

### DETAILED DESCRIPTION OF THE INVENTION

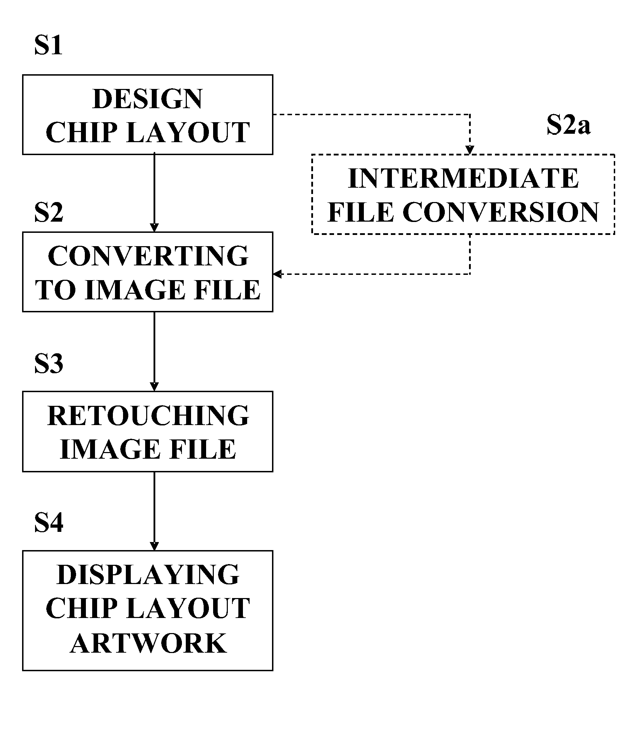

Figure 1 represents a diagram of the different steps of the transforming method of a chip layout into an artwork according to the present invention.

The first step S1 consists in designing a chip layout under computer-aided design software. The designed chip layout is stored under an original file format depending on the used computer-aided design software. One example of computer-aided circuit design that may be used for designing such chip layout is "Cadence design software". Original chip layout files under Cadence design software are stored with extension file gdsll.

The problem encountered with such original chip layout files is that they are not directly usable under image retouching software. Thus in order to retouch a chip layout file with image retouching software, the file format must be converted.

For that purpose, it is provided with step S2 to convert said original chip layout file format into an image file format, i.e. file extensions such as bmp, gif, jpeg, tiff, or any other compatible file extensions. This step S2 may be done directly if, on the one hand, the computer-aided design software allows it and if on the other hand the image retouching software recognizes available conversion formats of the computer-aided software.

Otherwise, according to a variant, an intermediary step S2a may be performed between steps S1 and S2. Step S2a consists in first converting said chip layout file into an intermediary file format, e.g. into a postscript file format. Before making a second conversion in a friendly image file format such as jpeg, bmp, tiff, etc.

Once again considering the example of a chip layout file under Cadence design software having a gdsll file extension, the intermediate conversion step is performed from the gdsll file to a postscript file followed by another file conversion from postscript file to a more friendly image file format such as bmp. The second conversion may be performed for example with GNU Image Manipulation Program (GIMP) freeware.

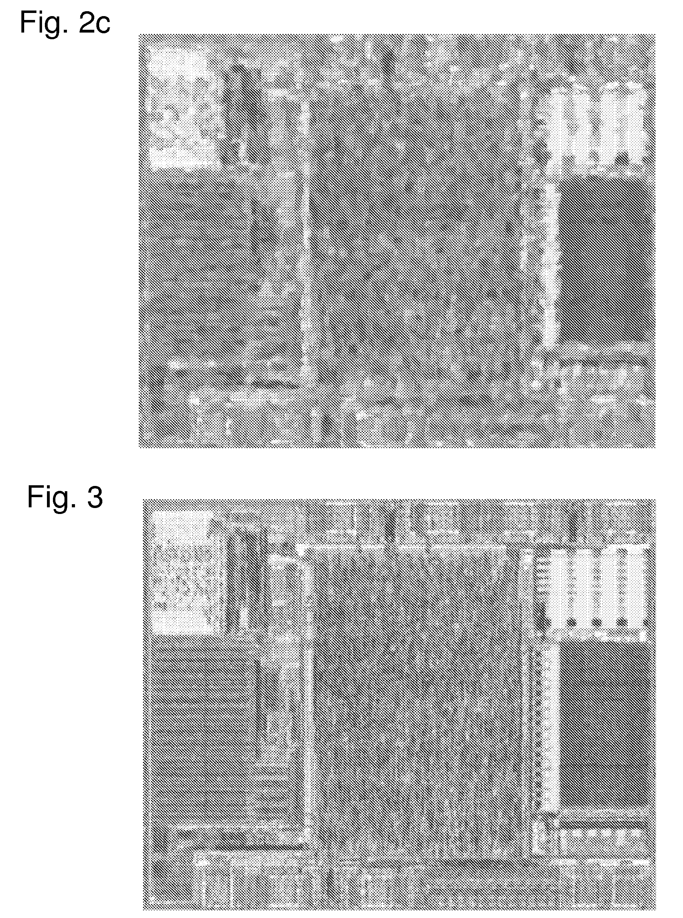

Then comes step S3 consisting in retouching the image file under image retouching software by applying some specific filter with at least two selected main parameters to transform the chip layout image into an artwork with some specific visual effect. Advantageously, the specific visual effect shall be such that when considering the original image and the resulting artwork after transformation, one should be able to recognize the specific visual effect applied. Detail examples of filters and corresponding specific visual effects will be given hereinafter in relation with Figures 2c to 6.

The visual effects of these filters are obtained via at least two main parameters available with image retouching software. These two main parameters may be chosen among with brushing strokes, brushing bristles, swirling, blurring, 3D surfacing, edge mode wrapping, blending, skewing, applying topography, solarizing, changing coordinates system... More generally what should be understood by main parameter is a parameter that modifies the layout topology in such a way that it is no longer usable as such, i.e. a chip layout. Some other minor parameters may be applied in addition to the main ones, among with resizing, rotating, colouring, darkening, lightening... More generally, what should be understood by minor parameter is a parameter that does not modify the layout topology.

Step S4 consists in displaying the resulting artwork after transformation with the specific filter applied. This displaying operation may be done in several ways among with displaying on a computer screen, printing on a sheet of paper or any other material or virtual display support.

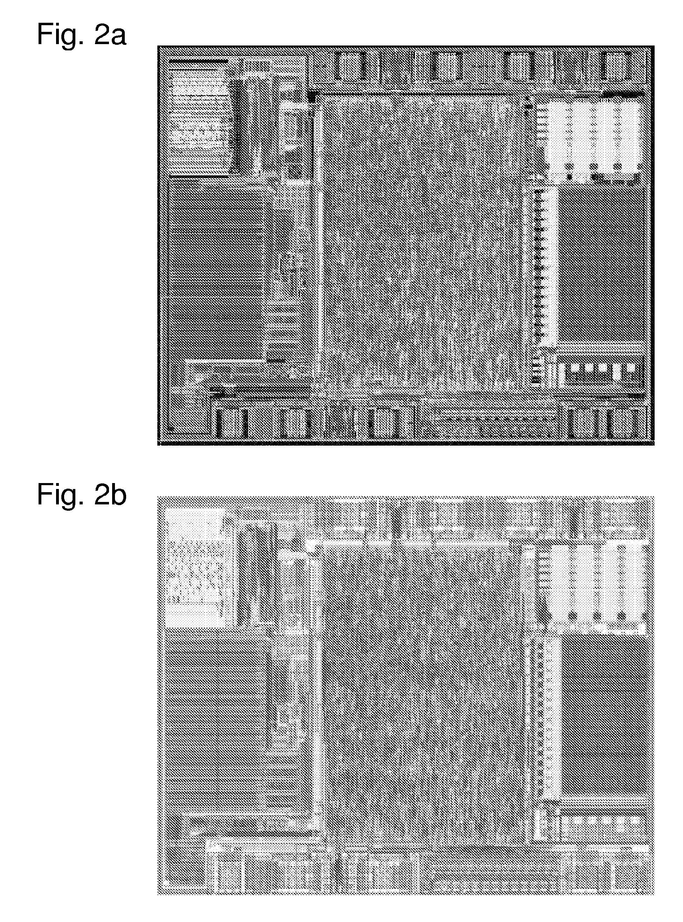

Figures 2a-2c represent one example of transforming a chip layout into an artwork according to the abovementioned method.

Figure 2a shows a designed chip layout as it appears on the screen of the computer under the computer-aided design software. Such chip layout presents specific features that make it recognizable among any other circuit designs. These features are in particular given by the colours, lines and shapes of the overall topology of the design. This original format of file is not directly readable by an image retouching software.

Figure 2b shows the same chip layout after conversion from the original chip layout file format to a readable file format with image retouching software. For the variant with an intermediate file conversion, it should be noticed that sampling, resizing, rotating and other simple operations may be also done with this intermediate software essentially used here for converting intermediate file into a more friendly image file.

Figure 2c shows a first example of artwork obtained with a first specific filter. This filter is called the "impressionist" filter in the sense that the resulting visual effect obtained looks like an impressionist painting. This impressionist filter comprises at least brushing strokes and brushing bristles with a large width and a small density in order to render a wide brushing effect.

Figure 3 shows a second example of artwork based on the same chip layout of Figure 2a and obtained with a second specific filter. This filter is called the "misty" filter in the sense that the resulting visual effect looks like a chip layout viewed through mist. This misty filter comprises at least brushing strokes and brushing bristles with a narrow width and a strong density in order to render a thin brushing effect.

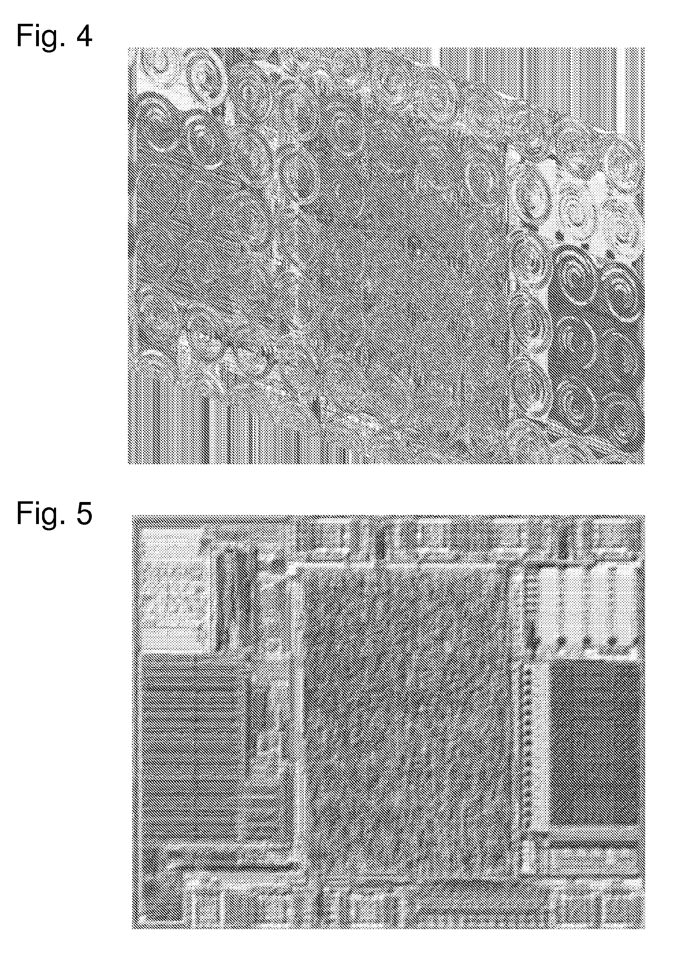

Figure 4 shows a third example of artwork still based on the same chip layout of Figure 2a and obtained with a third specific filter. This filter is called the "downpour" filter in the sense that the resulting visual effect looks like a chip layout viewed under a water flood. This downpour filter comprises at least swirling and 3D surfacing parameters. Advantageously, skewing effect could be added.

Figure 5 shows a fourth example of artwork still based on the same chip layout of Figure 2a and obtained with a fourth specific filter. This filter is called the "lunar" filter in the sense that the resulting visual effect looks like a lunar sea landscape. This lunar filter comprises at least topographic blurring and blending parameters.

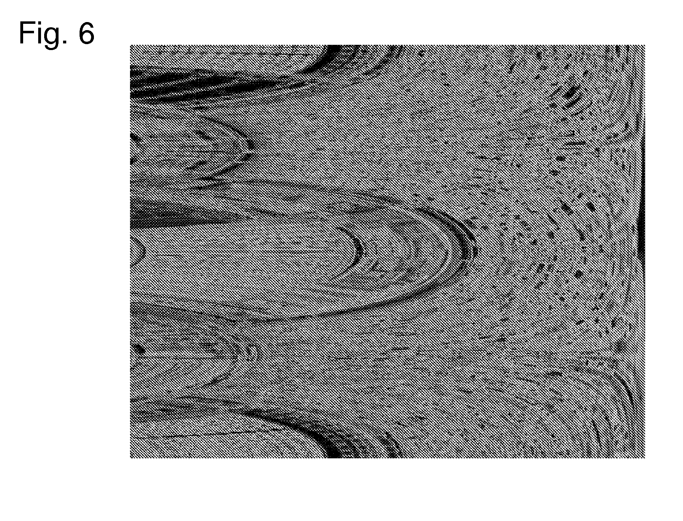

Figure 6 shows a fifth example of artwork still based on the same chip layout of Figure 2a and obtained with a fifth specific filter. This filter is called the "fireworks" filter in the sense that the resulting visual effect looks like a chip layout being burst out into a fireworks. This fireworks filter comprises at least changing coordinate system and solarizing parameters.

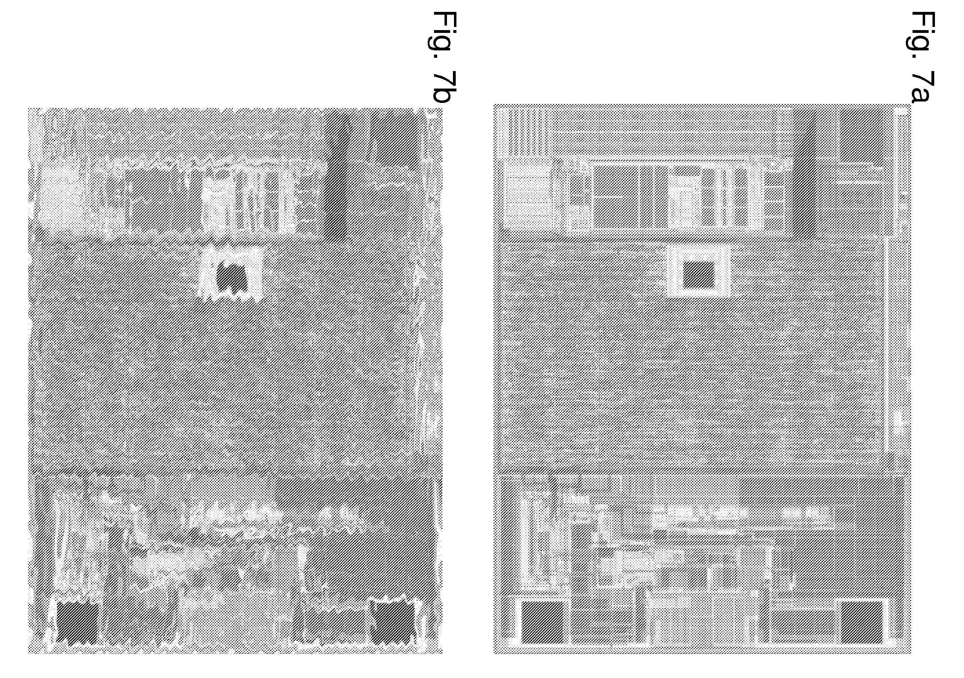

Figure 7a shows chip layout from the one shown in Figure 2a.

Figure 7b shows a sixth example of artwork based on the chip layout of Figure 7a and obtained with a sixth specific filter. This filter is called the "puddle" filter in the sense that the resulting visual effect looks like a chip layout viewed into a water plash or puddle. This puddle filter comprises at least blurring and blending parameters.

It is appreciated that the resulting artworks obtained by the transforming method above described may be advantageously used as pictures for a screensaver, as wallpaper either for computer screens or for house walls, also as pictures for calendar. In the calendar application, preferably one artwork would be used for one month picture.

Having described the invention with regard to certain specific parameters or visual effects, it is to be understood that these parameters or visual effects are not meant as limitations of the invention. Indeed, various modifications and/or adaptations may become apparent to those skilled in the art without departing from the scope of the annexed claims.

## Claims

1. A method for transforming a chip layout into an artwork comprising the steps of:
S1) designing a chip layout under a computer-aided design software having an original file format unreadable with an image retouching software;
S2) converting said original file format of the chip layout into a chip layout file having a file format readable with an image retouching software;
S3) retouching said image file into an artwork by applying a complex filter with at least two main parameters among with brushing strokes, brushing bristles, swirling, blurring, 3D surfacing, edge mode wrapping, blending, skewing, applying topography, solarizing, changing coordinates system;
S4) displaying said resulting artwork.

2. The method of claim 1, wherein at least one minor parameter is additionally applied, among with resizing, rotating, colouring, darkening, lightening.

3. The method of claim 1 or 2, wherein the applied filter is an impressionist filter using at least wide brushing strokes and brushing bristles at a low density.

4. The method of claim 1 or 2, wherein the applied filter is a misty filter using at least narrow brushing strokes and brushing bristles at a high density.

5. The method of claim 1 or 2, wherein the applied filter is a downpour filter using at least swirling and 3D surfacing.

6. The method of claim 5, wherein the downpour filter further uses skewing.

7. The method of claim 1 or 2, wherein the applied filter is a lunar filter using at least topographic blurring and blending.

8. The method of claim 1 or 2, wherein the applied filter is a fireworks filter using at least a coordinate system changing and solarizing.

9. The method of claim 1 or 2, wherein the applied filter is a puddle filter using at least blurring and blending.

10. A screensaver wherein images are transformed chip layout artworks obtained by the method according to any of claims 1 to 9.

11. A wallpaper for computer screen wherein an image is a transformed chip layout artwork obtained by the method according to any of claims 1 to 9.

12. A calendar, wherein calendar pictures are chip layout artworks obtained by the method according to any of claims 1 to 9.
